# EUROPEAN PATENT APPLICATION

(11) **EP 4 481 498 A1**
(43) Date of publication of application: **25.12.2024**
(21) Application number: 23756413.3
(22) Date of filing: 15.02.2023
(51) Int. Cl.: G03F 9/00, G03F 7/20, H01L 21/30

(54) **EXPOSURE METHOD, DEVICE MANUFACTURING METHOD, EXPOSURE DEVICE, AND EXPOSURE SYSTEM**

(30) Priority: 17.02.2022 JP 2022022940
(71) Applicant: NIKON CORPORATION, Minato-ku Tokyo 108-6290 (JP)
(72) Inventor: WATANABE, Yoji, Tokyo 108-6290 (JP)
(74) Representative: Hoffmann Eitle
(86) International application number: PCT/JP2023/005314
(87) International publication number: WO 2023/157888

(57) **Abstract**

An exposure method includes forming, by using an exposure device using a mask, a first exposure pattern in a first region of each of a plurality of pattern formation regions on a substrate with exposure light through a first mask, and forming a second exposure pattern in a second region spaced apart from the first region in each of the pattern formation regions with exposure light through a second mask, and forming an exposure pattern determined based on positions of the first and second exposure patterns between the first and second regions in each of the pattern formation regions with exposure light through a spatial light modulator, using an exposure device that uses the spatial light modulator that modulates exposure light based on an output from an exposure pattern determination unit.

## Description

### FIELD

The present disclosure relates to an exposure method, a device manufacturing method, an exposure device, and an exposure system.

### BACKGROUND

In advanced packaging technologies, large-area interposers are sometimes used to place multiple chips in parallel in a plane.

The interposer is a chip in which only wiring lines are formed, and is manufactured by a semiconductor manufacturing process. However, since a photomask used for exposure in the semiconductor manufacturing process has a fixed exposure size, a stitching exposure technique of forming a large pattern by exposure by stitching a plurality of patterns on a substrate is used to manufacture a large-area interposer (for example, Patent Document 1).

### Related Art Documents

### Patent Documents

Patent Document 1: U.S. Patent Application Publication No. 2017/0023732

### SUMMARY

According to a first aspect of the present disclosure, there is provided an exposure method including: forming, by using an exposure device using a mask, a first exposure pattern in a first region of each of a plurality of pattern formation regions on a substrate with exposure light through a first mask, and forming a second exposure pattern in a second region spaced apart from the first region in each of the pattern formation regions with exposure light through a second mask; and forming an exposure pattern determined based on positions of the first and second exposure patterns between the first and second regions in each of the pattern formation regions with exposure light through a spatial light modulator, using an exposure device that uses the spatial light modulator that modulates exposure light based on an output from an exposure pattern determination unit.

According to a second aspect of the present disclosure, there is provided an exposure method including: forming a first exposure pattern in a first region in a pattern formation region on a substrate; forming a second exposure pattern in a second region spaced apart from the first region in the pattern formation region; and forming an exposure pattern in a third region between the first region and the second region based on measurement results of a position of the first exposure pattern and a position of the second exposure pattern.

According to a third aspect of the present disclosure, there is provided a device manufacturing method including: processing a surface of the substrate using the first and second exposure patterns formed using the above exposure method as a mask; and processing the surface of the substrate using the exposure pattern formed in the third region using the above exposure method as a mask.

According to a fourth aspect of the present disclosure, there is provided an exposure device including: a substrate stage on which a substrate on which a first exposure pattern is formed in a first region within a pattern formation region and a second exposure pattern is formed in a second region spaced apart from the first region within the pattern formation region is placed; an exposure pattern determination unit configured to determine an exposure pattern based on measurement results of a position of the first exposure pattern and a position of the second exposure pattern; a spatial light modulator that modulates and emits incident light based on an output from the exposure pattern determination unit; an illumination optical system that irradiates the spatial light modulator with illumination light; and a projection optical system that projects an image of a light modulation surface of the spatial light modulator between the first and second regions.

According to a fifth aspect of the present disclosure, there is provided an exposure device including: a substrate stage on which a substrate on which wiring patterns are formed in a plurality of regions spaced apart from each other is placed; an exposure pattern determination unit configured to determine an exposure pattern based on measurement results of positions of the wiring patterns; a spatial light modulator that modulates and emits incident light based on an output from the exposure pattern determination unit; an illumination optical system that irradiates the spatial light modulator with illumination light; and a projection optical system that projects an image of a light modulation surface of the spatial light modulator between adjacent regions among the plurality of regions.

According to a sixth aspect of the present disclosure, there is provided an exposure system including: a first exposure device that forms exposure patterns in a plurality of regions spaced apart from each other in a pattern formation region on a substrate with exposure light through a plurality of masks, respectively; and a second exposure device that includes a spatial light modulator, which modulates exposure light based on an output from an exposure pattern determination unit, and forms an exposure pattern between adjacent regions of the plurality of regions with exposure light through the spatial light modulator.

The configuration of the embodiments described below may be modified appropriately, and at least some of the components may be substituted for other components. Further, the constituent elements whose arrangement is not particularly limited are not limited to the arrangement disclosed in the embodiment, and can be arranged at positions where the functions can be achieved.

### BRIEF DESCRIPTION OF DRAWINGS

FIG. 1 is a block diagram illustrating a configuration of an exposure system according to an embodiment;
FIG. 2 illustrates a schematic configuration of a first exposure device;
FIG. 3 illustrates a schematic configuration of an exposure device main unit of a second exposure device;
FIG. 4 illustrates an example of a spatial light modulator;
FIG. 5 is a functional block diagram of a pattern determination unit of the second exposure device;
FIG. 6 is a flowchart (part 1) illustrating an example of a method of manufacturing an interposer;
FIG. 7 is a flowchart (part 2) illustrating the example of the method of manufacturing the interposer;
FIG. 8A illustrates an example of an interposer having a line-and-space (L/S) pattern, FIG. 8B is a cross-sectional view of a wafer, and FIG. 8C illustrates a plurality of pattern formation regions on the wafer;
FIG. 9A is a view for describing a first region in a wafer, FIG. 9B illustrates an example of a first pattern, and FIG. 9C illustrates a state in which a first exposure pattern is formed in a pattern formation region;
FIG. 10A is a view for describing a second region in the wafer, FIG. 10B illustrates an example of a second pattern, and FIG. 10C illustrates a state in which a second exposure pattern is formed in the pattern formation region;
FIG. 11A is a view for describing a third region in the wafer, FIG. 11B illustrates an example of a third pattern, and FIG. 11C illustrates a state in which a third exposure pattern is formed in the pattern formation region;
FIG. 12A is a view for describing a fourth region in the wafer, FIG. 12B illustrates an example of a fourth pattern, and FIG. 12C illustrates a state in which a fourth exposure pattern is formed in the pattern formation region;
FIG. 13 illustrates an example of a patterned insulating layer;
FIG. 14A is a view for describing a first connection region and a second connection region, and FIG. 14B illustrates an example of a positional shift of a wiring pattern;
FIG. 15A illustrates an example of a connection pattern, FIG. 15B illustrates an example of a design value pattern, and FIG. 15C illustrates another example of the connection pattern;
FIG. 16A is a view for describing exposure of the first connection region by the second exposure device, and FIG. 16B is a view for describing exposure of the second connection region by the second exposure device;
FIG. 17 illustrates L/S patterns of interposers formed on a wafer;
FIG. 18 is a view for describing a case where a second layer is exposed over a first layer; and
FIG. 19A illustrates an example of a reticle, FIG. 19B illustrates an example of an exposure pattern formed by rotating the reticle, and FIG. 19C illustrates another example of the reticle.

### DESCRIPTION OF EMBODIMENTS

In the stitching exposure technique, for example, two patterns are used to form a large pattern by exposure by joining the two patterns on a substrate. However, when the joining accuracy between the patterns (hereinafter, referred to as stitching accuracy) deteriorates, the line width accuracy may deteriorate. Further, there is a possibility of a connection failure or a short circuit between the wiring lines. It is desired to achieve high throughput while ensuring high stitching accuracy.

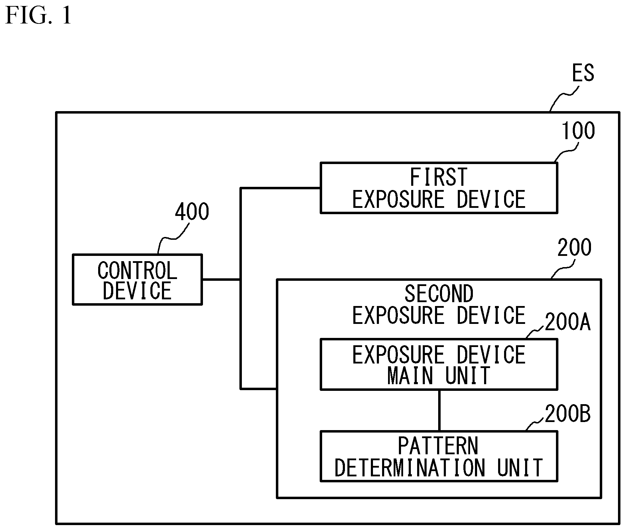

Hereinafter, an exposure system according to the present embodiment will be described with reference to FIG. 1 to FIG. 17.

FIG. 1 is a block diagram illustrating a configuration of an exposure system ES according to the present embodiment. As illustrated in FIG. 1, the exposure system ES includes a first exposure device 100, a second exposure device 200, and a control device 400.

In the following description, the case where the processing target of the first exposure device 100 and the second exposure device 200 is a wafer W0 will be described as an example. The control device 400 controls the overall operation of the exposure system ES.

### (First Exposure Device 100)

The first exposure device 100 is an exposure device that uses a reticle (photomask). The first exposure device 100 forms a pattern formed on a reticle onto a photosensitive layer of the wafer W0 by exposure.

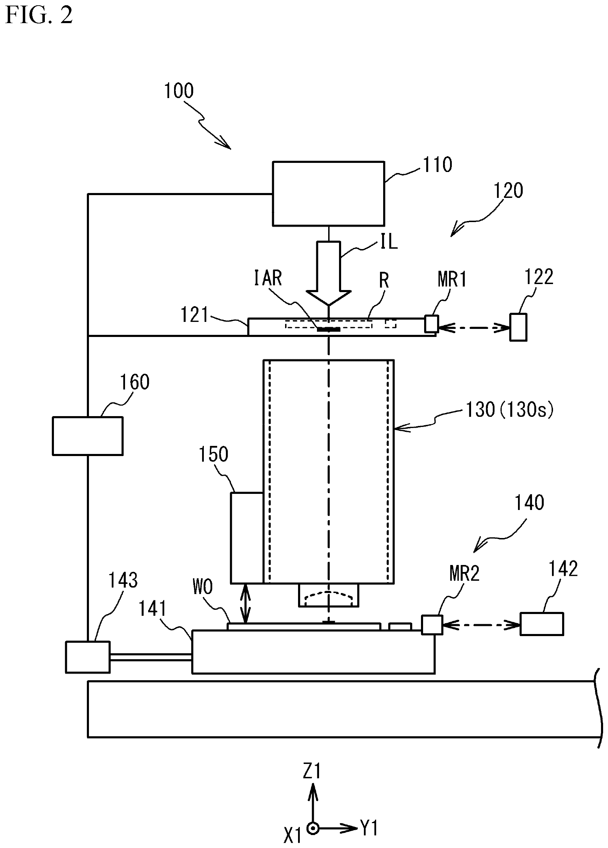

FIG. 2 illustrates a schematic configuration of the first exposure device 100. As illustrated in FIG. 2, the first exposure device 100 includes an illumination system 110, a reticle stage device 120, a projection optical system 130, a wafer stage device 140, an alignment detection system 150, and a first exposure control unit 160. In the description of the first exposure device 100, two directions orthogonal to each other in a horizontal plane are referred to as an X1 direction and a Y1 direction, and a vertical direction is referred to as a Z1 direction. The rotation (inclination) directions around the X1-axis, the Y1-axis, and the Z 1-axis are defined as a θx1 direction, a θy1 direction, and a θz1 direction, respectively.

The illumination system 110 includes a light source and an illumination optical system (none of which are illustrated) connected to the light source via a light transmission optical system. The light source is, for example, an ArF excimer laser light source (wavelength: 193 nm). The illumination optical system irradiates an illumination area IAR on a reticle R held by a reticle stage 121 of the reticle stage device 120 with illumination light from the light source at a substantially uniform illuminance. The illumination area IAR is a slit-shaped area extending elongatedly in the X1 direction.

The reticle stage device 120 includes the reticle stage 121 and a reticle laser interferometer 122.

The reticle stage 121 holds the reticle R via a holder provided on the reticle stage 121. The reticle stage 121 can be finely driven in the X1 direction and the Z1 direction by a reticle stage driving system (not illustrated), and can be driven in a predetermined stroke range in the scanning direction (Y1 direction).

The reticle laser interferometer 122 constantly detects the positions of the reticle stage 121 in the X1 direction, the Y1 direction, and the θz1 direction with a resolution of, for example, about 0.25 nm by irradiating moving mirrors (in FIG. 2, only a moving mirror MR1 provided on the end face in the Y1 direction is illustrated), which are provided on the end faces of the reticle stage 121 in the X1 and Y1 directions, with length measurement beams.

The projection optical system 130 reduces and projects a pattern formed on the reticle R onto the wafer W0 placed on a wafer stage 141 (to be described later) at a predetermined projection magnification (for example, 1/4 times, 1/5 times, 1/8 times, or the like). The optical system includes a lens barrel 130s and a plurality of optical elements (not illustrated) arranged in a predetermined positional relationship inside the lens barrel 130s.

The wafer stage device 140 includes the wafer stage 141 and a laser interferometer 142. The wafer stage 141 holds the wafer W0 via a wafer holder (not illustrated) provided at the center of the upper surface thereof. The wafer stage 141 is driven by a stage driving system 143 in the X1 direction and the Y1 direction with a predetermined stroke, and is finely driven in the Z1 direction, the θx1 direction, the θy1 direction, and the θz1 direction.

The laser interferometer 142 constantly detects the positional information of the wafer stage 141 in the X1 direction, the Y1 direction, the θz1 direction, the θx1 direction, and the θy1 direction with a resolution of, for example, about 0.25 nm, by irradiating moving mirrors (in FIG. 2, only a moving mirror MR2 provided on the end face in the Y1 direction is illustrated), which are provided on the end faces of the wafer stage 141 in the X1 direction and the Y1 direction, with length measurement beams.

The alignment detection system 150 is provided on the side face of the lens barrel 130s of the projection optical system 130. The alignment detection system 150 detects alignment marks or the like formed on the wafer. As the alignment detection system 150, a field image alignment (FIA) system, which is a kind of image-processing type imaging alignment sensor, can be used. Instead of or in addition to the alignment system of the image processing type, an alignment system of a diffracted light interference type may be used.

The first exposure control unit 160 comprehensively controls the illumination system 110, the reticle stage device 120, the projection optical system 130, and the wafer stage device 140, and forms an image of a pattern formed on the reticle R held by the reticle stage device 120 onto the wafer W0 held by the wafer stage 141 via the projection optical system 130 by exposure. The first exposure control unit 160 of the present embodiment controls each unit to perform exposure by a step-and-scan method.

The exposure device disclosed in U.S. Patent No. 10684562 may be used as the first exposure device 100 having the above configuration.

### (Second Exposure Device 200)

The second exposure device 200 is an exposure device using a spatial light modulator (SLM) that modulates exposure light in accordance with control by a second exposure control unit 260 described later. The second exposure device 200 includes an exposure device main unit 200A and a pattern determination unit 200B.

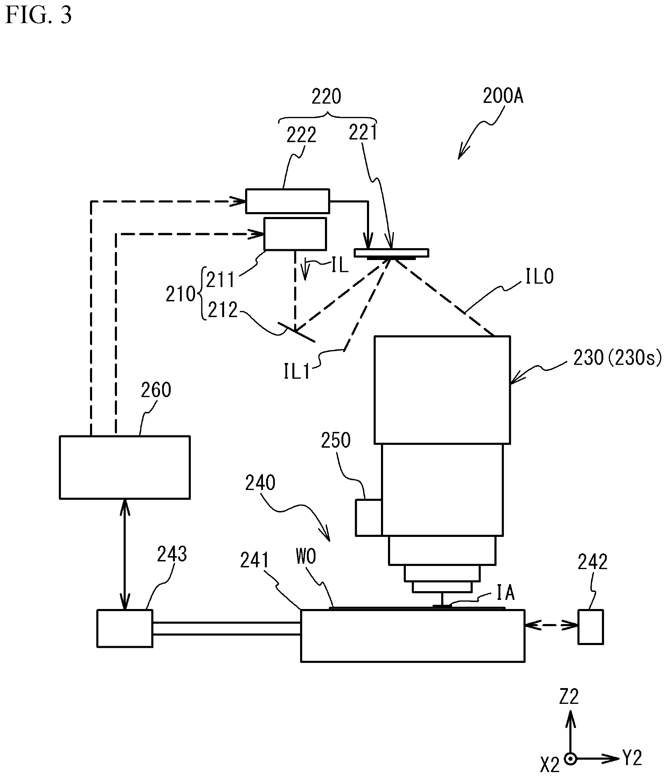

FIG. 3 illustrates a schematic configuration of the exposure device main unit 200A. As illustrated in FIG. 3, the exposure device main unit 200A includes an illumination system 210, a pattern generation device 220, a projection optical system 230, a stage device 240, an alignment detection system 250, and the second exposure control unit 260. In the description of the exposure device main unit 200A, two directions orthogonal to each other in a horizontal plane are referred to as an X2 direction and a Y2 direction, and a vertical direction is referred to as a Z2 direction. The rotation (inclination) directions around the X2-axis, the Y2-axis, and the Z2-axis are defined as a θx2 direction, a θy2 direction, and a θz2 direction, respectively.

The illumination system 210 includes a light source unit (not illustrated), an illumination optical system 211, and a reflection mirror 212. The light source system includes, for example, a solid-state laser light source (a DFB semiconductor laser, a fiber laser, or the like). The illumination optical system 211 includes a shaping optical system, an optical integrator, a field stop, and a relay lens system (none of which are illustrated) for changing the illumination condition.

The pattern generation device 220 generates a pattern to be projected onto a photosensitive layer of the wafer W0 placed on a stage 241 (to be described later) of the stage device 240 according to the control by the second exposure control unit 260. The pattern generation device 220 includes a spatial light modulator 221 and a drive unit 222.

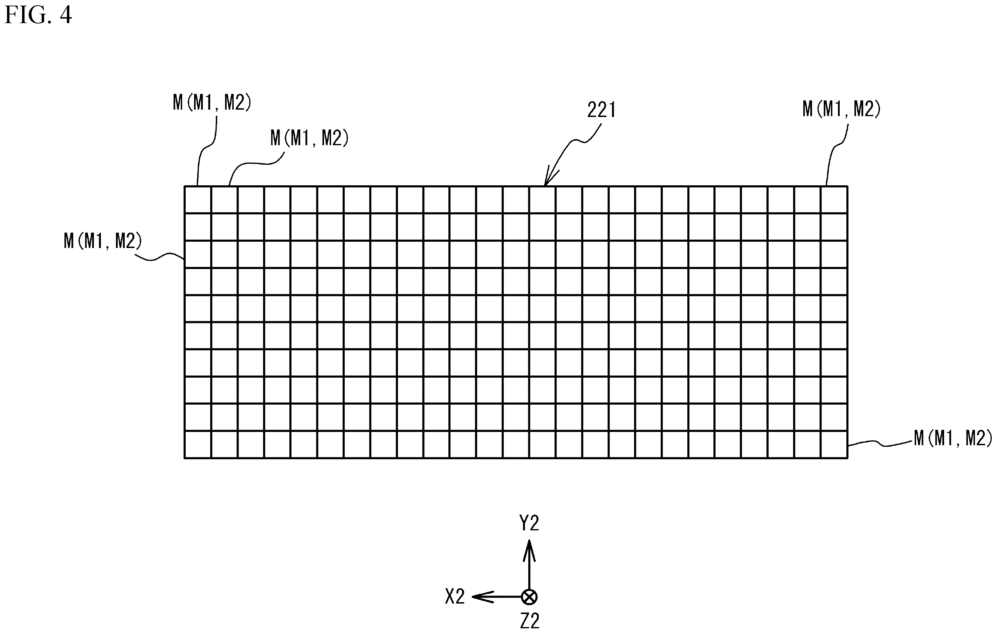

FIG. 4 illustrates an example of the spatial light modulator 221. As illustrated in FIG. 4, the spatial light modulator 221 has a plurality of micromirror mechanisms M arranged in a matrix (two dimensional, array) in the X2-Y2 plane. Each of the micromirror mechanisms M includes a micromirror M1 and a drive mechanism M2 provided on the opposite side of the micromirror M1 from the reflection surface. The drive mechanism M2 moves the micromirror M1 along an axis extending in the Z2 direction, that is, moves the micromirror M1 up and down.

The drive unit 222 drives the drive mechanism M2 of each of the micromirror mechanisms M in accordance with a control signal from the second exposure control unit 260, and switches the micromirror M1 between an ON state (ON position) and an OFF state (OFF position).

Since the size of each micromirror M1 is too small to be resolved by the projection optical system 230, when all the micromirrors M1 are in the ON state or OFF state in the region of the size that can be resolved by the projection optical system 230, the 0-order diffracted light IL0 of the illumination light IL from the illumination system 210 that enters the region enters the projection optical system 230. For example, 2 × 2 micromirrors M1 may be located in a region having a size that can be resolved by the projection optical system 230. On the other hand, when the illumination light IL from the illumination system 210 enters the region where the micromirrors M1 in the ON state and the micromirrors M1 in the OFF state are alternately positioned, the illumination light IL is diffracted in this region, the 0-order diffracted light IL0 of the illumination light IL is almost lost, and ±1st order and higher diffracted light IL1 of the illumination light IL reaches the non-exposure optical path that is out of the projection optical system 230. The pattern generation device 220 gives a pattern to the illumination light IL by setting each of the micromirrors M1 to either the ON state or the OFF state. In the following description, a surface on which the micromirrors M1 set to either the ON state or the OFF state are arranged may be referred to as a light modulation surface of the spatial light modulator 221. Typically, the light modulation surface is substantially parallel to the X2-Y2 plane.

The spatial light modulator 221 is not limited to a piston type described above, and may be, for example, a magneto-optic spatial light modulator (MOSAM) or a digital mirror device (DMD). Further, although the spatial light modulator 221 has been described as a reflective type that reflects the illumination light IL, the spatial light modulator 221 may be a transmissive type that transmits the illumination light IL, or a diffractive type that diffracts the illumination light IL. The spatial light modulator 221 may be any spatial light modulator as long as it can spatially and temporally modulate the illumination light IL.

The projection optical system 230 reduces and projects an image of the light modulation surface of the spatial light modulator 221 onto the wafer W0 placed on the stage 241 at a projection magnification β (for example, β = 1/200, 1/400, 1/500, or the like). That is, an exposure pattern is formed on the wafer W0 by the energy beam through the pattern generation device 220. The optical system includes a lens barrel 230s and a plurality of optical elements (not illustrated) arranged in a predetermined positional relationship inside the lens barrel 230s.

The stage device 240 includes the stage (substrate stage) 241, a laser interferometer 242, and a stage drive unit 243.

The stage 241 holds the wafer W0 via a wafer holder (not illustrated) provided at the center of the upper surface. The stage 241 is movable in the X2 direction, the Y2 direction, and the Z2 direction by the stage drive unit 243, and is rotatable around the axis extending in the Z2 direction.

The laser interferometer 242 constantly detects the positions of the stage 241 in the X2 direction, the Y2 direction, and the θz2 direction with a resolution of , for example, about 0.5 to 1 nm, by irradiating the reflection surfaces provided on the end faces of the stage 241 in the X2 direction and the Y2 direction, respectively, with length measurement beams.

The stage drive unit 243 drives the stage 241 in accordance with a control signal from the second exposure control unit 260.

The alignment detection system 250 is arranged on a side surface of the projection optical system 230. In the present embodiment, an imaging alignment sensor is used as the alignment detection system 250. The detailed configuration of the alignment detection system 250 is disclosed in, for example, U.S. Patent No. 5,637,129.

The alignment detection system 250 detects street lines or position detection marks formed on the wafer W0. The detection results of the street lines or the position detection marks by the alignment detection system 250 are output to the second exposure control unit 260.

The alignment detection system 250 detects alignment marks included in the wiring patterns formed on the wafer W0. The wiring pattern is formed based on the exposure pattern formed on the wafer W0 by the first exposure device 100. Therefore, the alignment detection system 250 can also be said to detect the alignment marks included in the exposure pattern formed on the wafer W0 by the first exposure device 100. The detection results of the alignment marks by the alignment detection system 250 are output to the pattern determination unit 200B.

The pattern determination unit 200B determines a pattern to be formed by exposure on the photosensitive layer of the wafer W0 based on the detection results of the alignment marks (the positions of the wiring patterns (exposure patterns)) on the wafer W0 by the alignment detection system 250. The pattern determination unit 200B outputs the determined exposure pattern to the second exposure control unit 260.

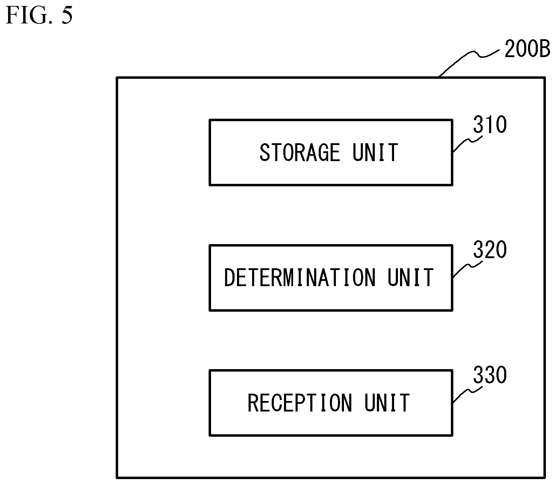

FIG. 5 is a functional block diagram of the pattern determination unit 200B. The pattern determination unit 200B is, for example, a personal computer (PC), and includes a storage unit 310, a determination unit 320, and a reception unit 330.

The storage unit 310 stores various kinds of data used to determine a pattern to be formed by exposure on the photosensitive layer of the wafer W0. The determination unit 320 determines a pattern to be formed by exposure on the photosensitive layer of the wafer W0 based on the data stored in the storage unit 310 and the detection results of the alignment marks on the wafer W0 by the alignment detection system 250. The reception unit 330 receives an output from the alignment detection system 250 of the second exposure device 200, and transmits it to the determination unit 320.

The details of the process executed by the determination unit 320 of the pattern determination unit 200B will be described later.

The pattern determination unit 200B may be separate from the second exposure device 200, instead of being a part of the second exposure device 200. That is, the second exposure device 200 may not necessarily include the pattern determination unit 200B. In this case, the detection results of the alignment marks by the alignment detection system 250 are transmitted to a server outside the second exposure device 200, and the server determines the pattern and transmits the determined pattern to the second exposure device 200 (specifically, the second exposure control unit 260).

Referring back to FIG. 3, the second exposure control unit 260 controls the operations of the illumination system 210, the pattern generation device 220, the stage device 240, and the like so as to form the exposure pattern determined by the pattern determination unit 200B on the wafer W0, and projects the image of the light modulation surface of the spatial light modulator 221 onto the wafer W0 held by the stage 241 through the projection optical system 230.

When the spatial light modulator 221 is illuminated with the illumination light IL from the illumination system 210, the illumination light IL reflected by the micromirrors M1 of the spatial light modulator 221, i.e., the illumination light IL patterned by the spatial light modulator 221, enters the projection optical system 230, and a reduced image (partially inverted image) of the pattern is formed in the projection area IA on the wafer W0 held by the stage 241.

In the present embodiment, the second exposure control unit 260 performs exposure by a step-and-scan method. Further, the second exposure control unit 260 moves the stage 241 at an appropriate speed during the scan exposure, and scrolls the pattern generated by the spatial light modulator 221 in synchronization with the movement of the stage (that is, changes the shape of the pattern generated by the spatial light modulator 221).

As the second exposure device 200 having the above configuration, the exposure device disclosed in U.S. Patent No. 8089616, U.S. Patent Application Publication No. 2020/00257205, or International Publication No. 2005/081034 may be used.

### (Interposer Manufacturing Method)

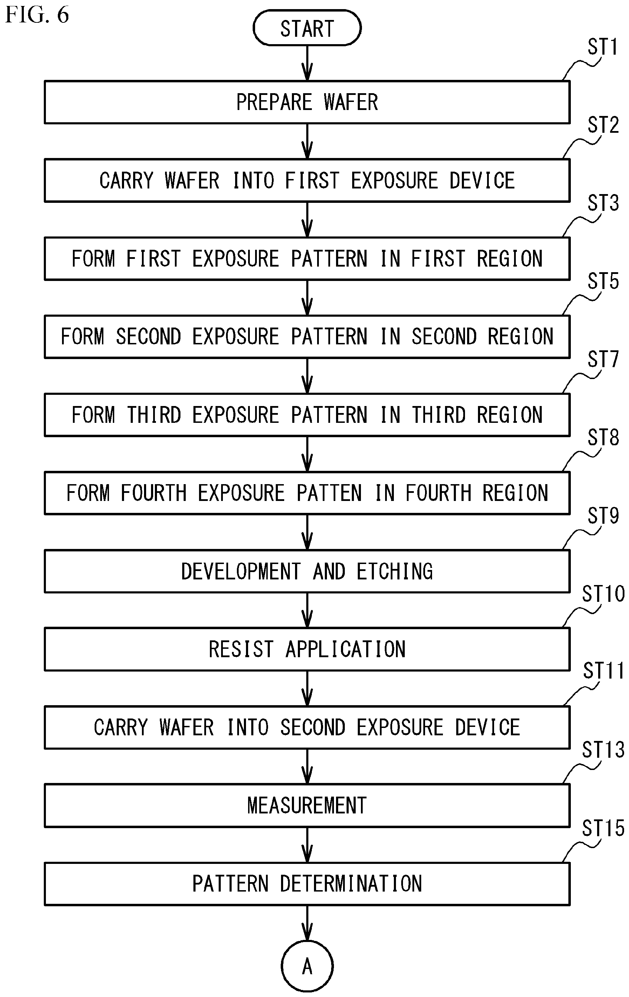

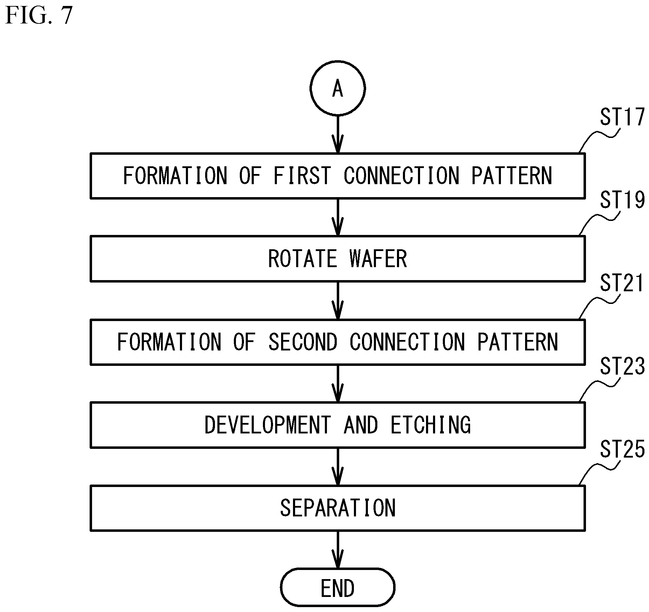

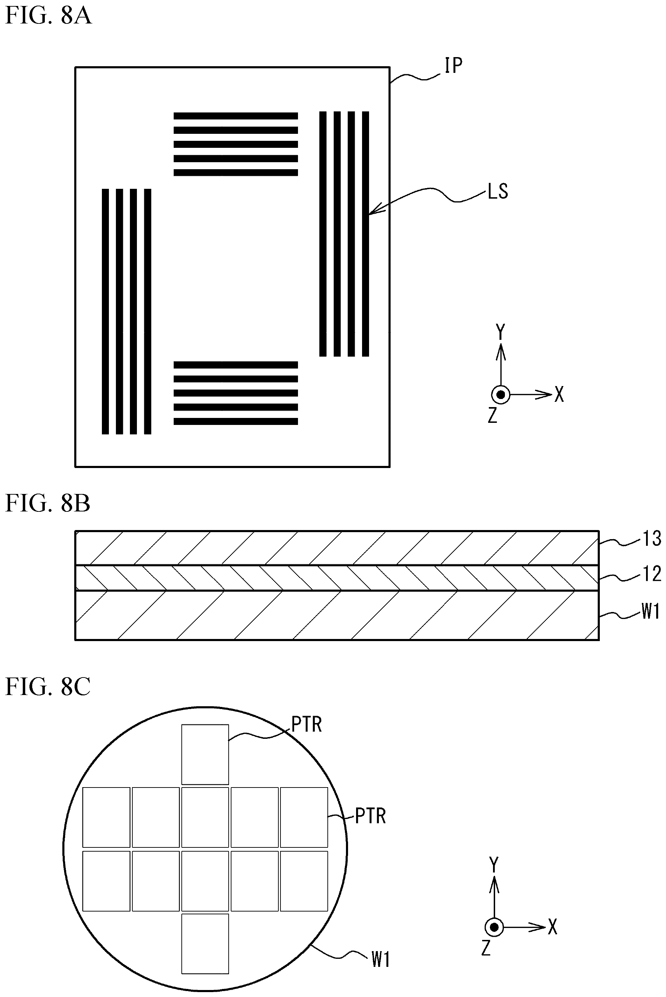

An interposer manufacturing method for manufacturing an interposer using the exposure system ES described above will be described with reference to the flowcharts of FIG. 6 and FIG. 7. Hereinafter, as an example, a case of manufacturing an interposer IP having a line and space (L/S) pattern LS illustrated in FIG. 8A will be described. The area of the interposer IP is larger than the area of the projection region of the first exposure device 100 onto which the image of the pattern formed on the reticle R is projected.

In the method illustrated in FIG. 6, first, a wafer to be exposed (hereinafter, referred to as a wafer W1) is prepared (step ST1). FIG. 8B is a cross-sectional view of the wafer W1, and FIG. 8C is a plan view of the wafer W1.

As illustrated in FIG. 8B, for example, an insulating layer 12 and a photosensitive layer 13 are stacked on the surface of the wafer W1 in this order from the bottom. The wafer W1 is made of, for example, silicon, glass, or an organic material. The insulating layer 12 is an insulating layer of SiO₂ or the like, for example. The photosensitive layer 13 is, for example, a photoresist.

As illustrated in FIG. 8C, a plurality of pattern formation regions PTR are defined on the wafer W1. By forming a predetermined exposure pattern in each pattern formation region PTR, the interposer IP having the L/S pattern LS can be formed. In the following description, the shorter direction of the pattern formation region PTR on the wafer W1 is defined as an X direction, the longer direction of the pattern formation region PTR is defined as a Y direction, and the normal direction of the wafer W1 is defined as a Z direction. Further, the rotation (inclination) directions about the X-axis, the Y-axis, and the Z-axis are defined as a θx direction, a θy direction, and a θz direction, respectively.

Referring back to FIG. 6, the wafer W1 is carried into the first exposure device 100 (step ST2). The wafer W1 carried into the first exposure device 100 is placed on the wafer stage 141. At this time, the wafer W1 is placed on the wafer stage 141 so that the X-axis of the wafer W1 and the X1-axis of the first exposure device 100 are aligned.

Then, the first exposure device 100 forms a first exposure pattern EPT1 in a first region ER1 of each of the pattern formation regions PTR on the wafer W1 with the exposure light through the first reticle R1 (step ST3).

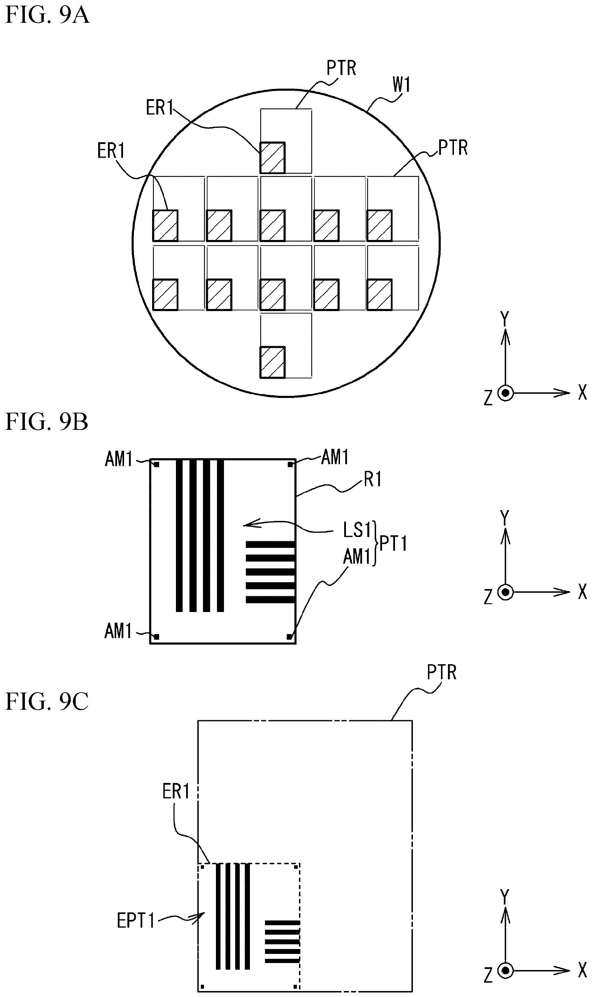

FIG. 9A is a view for describing the first region ER1. As illustrated in FIG. 9A, the first region ER1 is, for example, a lower left region in the pattern formation region PTR corresponding to the interposer IP.

FIG. 9B illustrates an example of a first pattern PT1 formed on the first reticle R1. As illustrated in FIG. 9B, the first pattern PT1 includes a first L/S pattern LS1 and alignment marks AM1. The first pattern PT1 may include a pattern such as a pad.

The first exposure device 100 drives the wafer stage 141 to sequentially expose the first regions ER1 to the image of the first pattern PT1 formed on the first reticle R1. As a result, as illustrated in FIG. 9C, the first exposure pattern EPT1 is formed in the lower left region (first region ER1) of the pattern formation region PTR.

Referring back to FIG. 6, when the formation of the first exposure pattern EPT1 is completed, the first exposure device 100 forms a second exposure pattern EPT2 in a second region ER2 spaced apart from the first region ER1 in each of the pattern formation regions PTR with the exposure light through a second reticle R2 (step ST5).

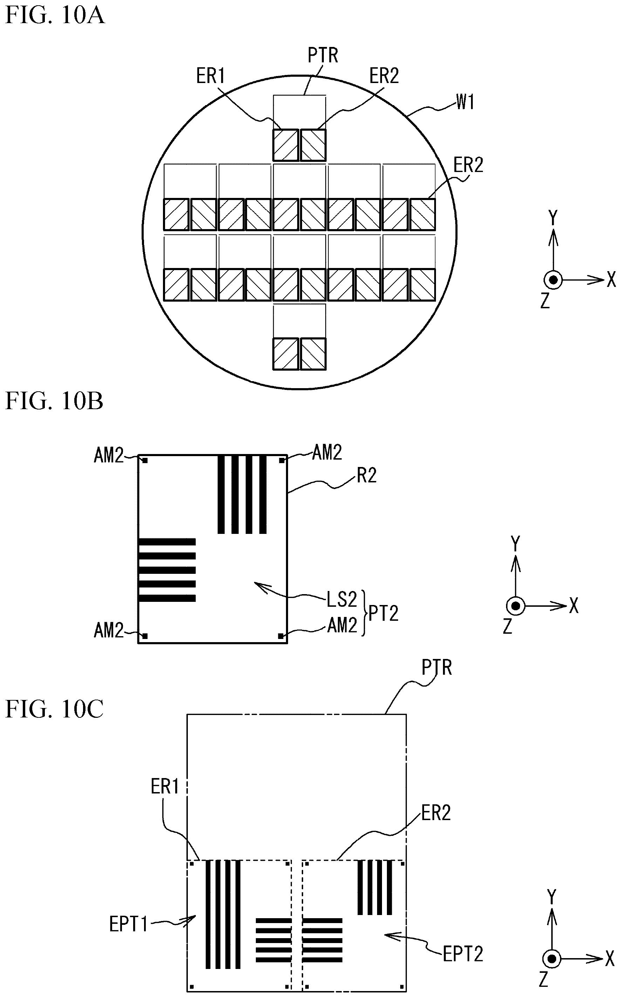

FIG. 10A is a view for describing the second region ER2. As illustrated in FIG. 10A, the second region ER2 is, for example, a lower right region in the pattern formation region PTR corresponding to the interposer IP. In the present embodiment, the first region ER1 and the second region ER2 are adjacent to each other in the X direction. In the present embodiment, "adjacent" means being spaced apart from and next to each other. The same applies to the following description.

FIG. 10B illustrates an example of the second pattern PT2 formed on the second reticle R2. As illustrated in FIG. 10B, the second pattern PT2 includes a second L/S pattern LS2 and alignment marks AM2. The second pattern PT2 may include a pattern such as a pad.

In the present embodiment, the first exposure device 100 includes a reticle changer capable of replacing a plurality of reticles, and when the formation of the first exposure pattern EPT1 is completed, the first reticle R1 is replaced with the second reticle R2 by the reticle changer. After the formation of the first exposure pattern EPT1 is completed, the wafer W1 may be carried out from the first exposure device 100, and the second exposure pattern EPT2 may be formed in the second region ER2 using another first exposure device 100 in which the second reticle R2 is set. That is, a plurality of the first exposure devices 100 may be provided. The reticle stage 121 may be able to mount multiple reticles.

The first exposure device 100 drives the wafer stage 141 to sequentially expose the second regions ER2 in the wafer W1 to the image of the second pattern PT2 formed on the second reticle R2. Thus, as illustrated in FIG. 10C, the second exposure pattern EPT2 is formed in the lower right region (second region ER2) of the pattern formation region PTR.

Referring back to FIG. 6, when the formation of the second exposure pattern EPT2 is completed, the first exposure device 100 forms a third exposure pattern EPT3 in a third region ER3 in each of the pattern formation regions PTR on the wafer W1 with the exposure light through a third reticle R3 (step ST7).

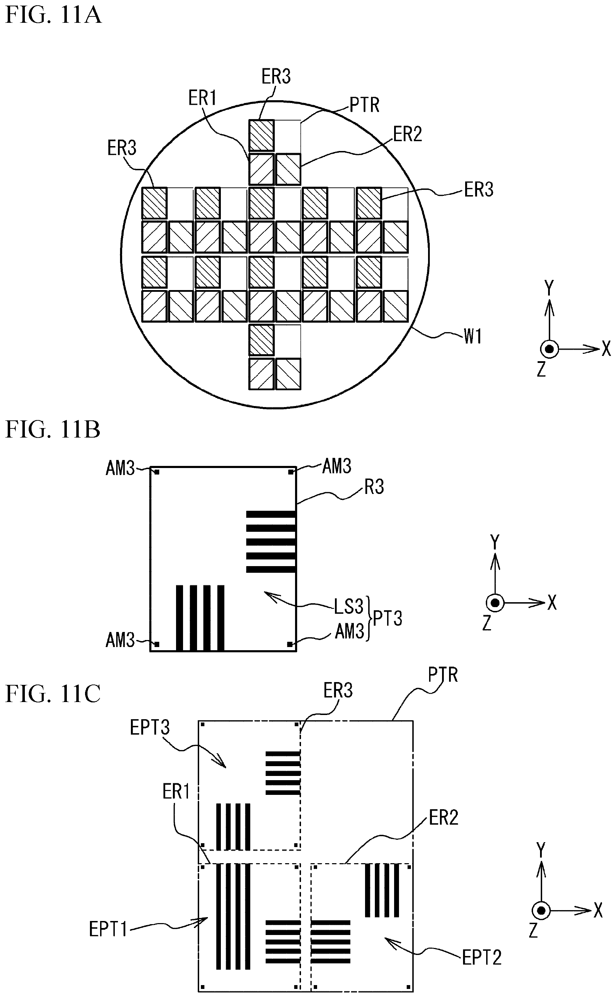

FIG. 11A is a view for describing the third region ER3. As illustrated in FIG. 11A, the third region ER3 is, for example, an upper left region in the pattern formation region PTR corresponding to the interposer IP. The third region ER3 is different from the first region ER1 and the second region ER2, and is a region adjacent to the first region ER1 in the Y direction intersecting the X direction.

FIG. 11B illustrates an example of a third pattern PT3 formed on the third reticle R3. As illustrated in FIG. 11B, the third pattern PT3 includes a third L/S pattern LS3 and alignment marks AM3. The third pattern PT3 may include a pattern such as a pad.

The first exposure device 100 replaces the second reticle R2 with the third reticle R3 by the reticle changer, and then drives the wafer stage 141 to sequentially expose the third regions ER3 in the wafer W1 to the image of the third pattern PT3 formed on the third reticle R3. As a result, as illustrated in FIG. 11C, the third exposure pattern EPT3 is formed in the upper left region (third region ER3) of the pattern formation region PTR.

Referring back to FIG. 6, when the formation of the third exposure pattern EPT3 is completed, the first exposure device 100 forms a fourth exposure pattern EPT4 in a fourth region ER4 in each of the pattern formation regions PTR on the wafer W1 with the exposure light through a fourth reticle R4 (step ST8).

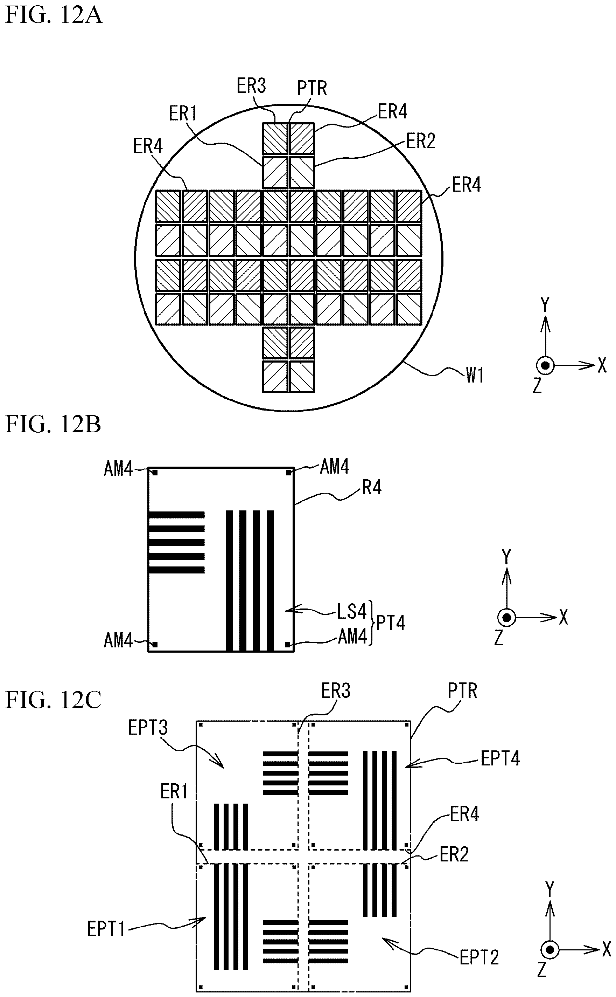

FIG. 12A is a view for describing the fourth region ER4. As illustrated in FIG. 12A, the fourth region ER4 is, for example, an upper right region in the pattern formation region PTR corresponding to the interposer IP. The fourth region ER4 is different from the first region ER1 to the third region ER3, and is a region adjacent to the third region ER3 in the X direction and adjacent to the second region ER2 in the Y direction.

FIG. 12B illustrates an example of the fourth pattern PT4 formed on the fourth reticle R4. As illustrated in FIG. 12B, the fourth pattern PT4 includes a fourth L/S pattern LS4 and alignment marks AM4. The fourth pattern PT4 may include a pattern such as a pad.

The first exposure device 100 replaces the third reticle R3 with the fourth reticle R4 by the reticle changer, and then drives the wafer stage 141 to sequentially expose the fourth regions ER4 to the image of the fourth pattern PT4 formed on the fourth reticle R4. As a result, as illustrated in FIG. 12C, the fourth exposure pattern EPT4 is formed in the upper right region (fourth region ER4) of the pattern formation region PTR.

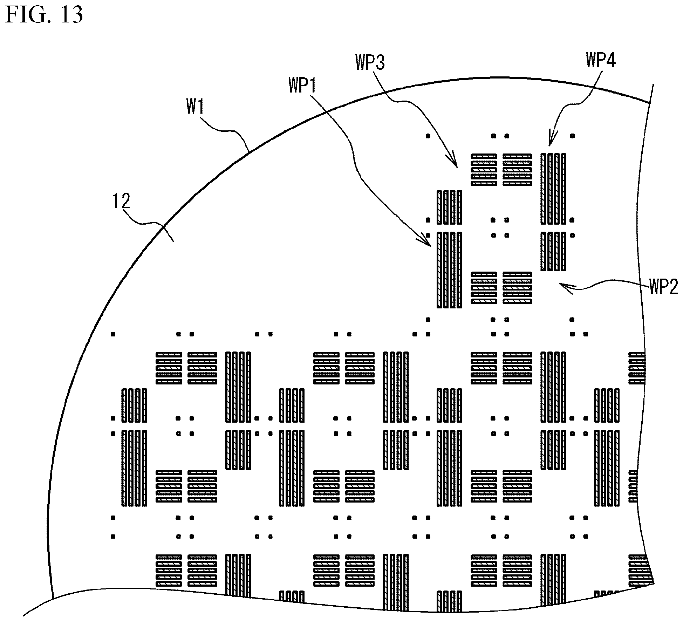

Referring back to FIG. 6, when the formation of the fourth exposure pattern EPT4 is completed, the wafer W1 is carried out from the first exposure device 100, and is developed and etched (step ST9). Specifically, the insulating layer 12 (the surface of the wafer W 1) formed on the surface of the substrate 11 is etched using the first exposure pattern EPT1 to the fourth exposure pattern EPT4 as a mask. Thus, the insulating layer 12 is patterned as illustrated in FIG. 13. More specifically, in a step described later, wiring patterns WP1 to WP4 for embedding metals in the patterned insulating layer 12 are formed. In FIG. 13, the etched insulating layer 12 is illustrated by hatching. The widths of the wiring lines included in the wiring patterns WP1 to WP4 are, for example, 200 nm or less. The widths of the wiring lines included in the wiring patterns WP1 to WP4 may be, for example, 400 nm or less.

When development and etching are completed, the resist is applied again to the wafer W1 (step ST10).

Then, the wafer W1 is carried into the exposure device main unit 200A of the second exposure device 200 (step ST11). When the wafer W1 is carried into the exposure device main unit 200A, the wafer W1 is pre-aligned by a pre-alignment system (not illustrated), and then placed on the stage 241. At this time, the wafer W1 is placed on the stage 241 so that the X-axis of the wafer W2 and the X2-axis of the second exposure device 200 are aligned. As the configuration of the pre-alignment system, the configuration described in U.S. Patent No. 6,624,433 can be adopted.

Then, the alignment detection system 250 detects the alignment marks AM1 to AM4 formed on the wafer W 1, thereby measuring the positions of the alignment marks AM1 to AM4 (step ST13). The measurement results of the positions of the alignment marks AM1 to AM4 are output to the pattern determination unit 200B.

Then, the pattern determination unit 200B determines the exposure patterns to be formed in a first connection region CR1 and a second connection region CR2 based on the measurement results of the positions of the alignment marks AM1 to AM4 (step ST15). More specifically, the exposure patterns (hereinafter, referred to as connection patterns) formed in the first connection region CR1 and the second connection region CR2 are determined based on the positions of the wiring patterns WP1 to WP4 obtained from the measurement results of the positions of the alignment marks AM1 to AM4.

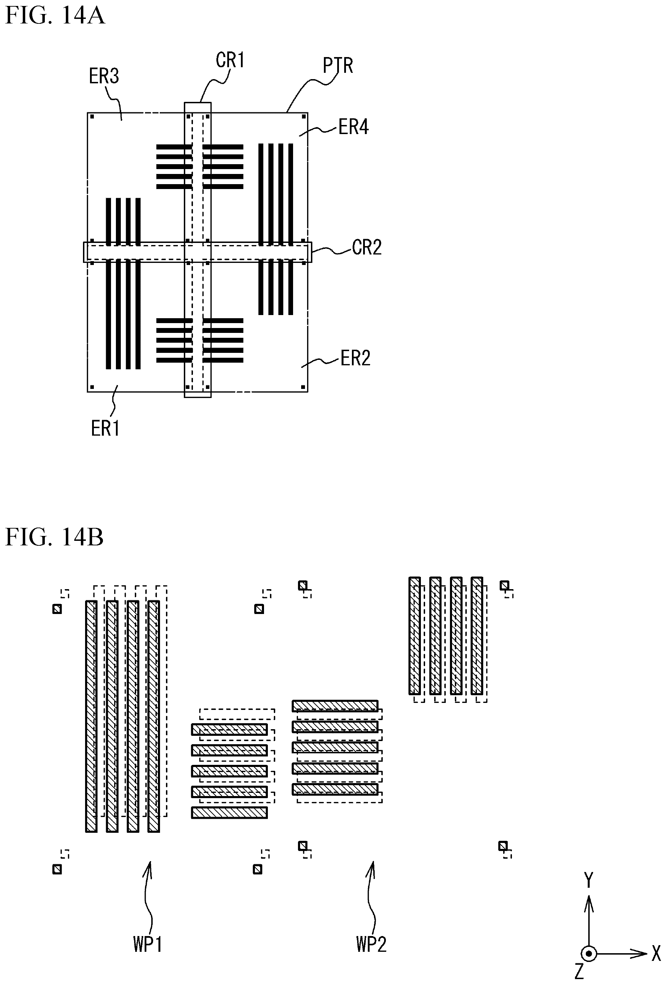

FIG. 14A is a diagram for describing the first connection region CR1 and the second connection region CR2. As illustrated in FIG. 14A, the first connection region CR1 is a region including a region between the first region ER1 and the second region ER2 and a region between the third region ER3 and the fourth region ER4. The second connection region CR2 is a region including a region between the first region ER1 and the third region ER3 and a region between the second region ER2 and the fourth region ER4.

In order to form the L/S pattern LS of the interposer IP illustrated in FIG. 8A, the wiring patterns WP1 to WP4 formed in each of the first region ER1, the second region ER2, the third region ER3, and the fourth region ER4, respectively, need to be connected to each other. Here, in the first exposure device 100, when the first exposure pattern EPT1 to the fourth exposure pattern EPT4 are formed in the first region ER1 to the fourth region ER4, respectively, the formation positions of the first exposure pattern EPT1 to the fourth exposure pattern EPT4 may be shifted from the design positions. In this case, the wiring patterns WP1 to WP4 are also formed to be shifted from the design positions.

FIG. 14B illustrates an example of the positional shifts of the wiring patterns WP1 and WP2. In FIG. 14B, the design positions of the wiring patterns WP1 and WP2 are indicated by dotted lines, and the actual positions of the wiring patterns WP1 and WP2 are indicated by solid lines.

In the example of FIG. 14B, the wiring pattern WP1 is shifted in the -X direction and the -Y direction with respect to the design position, and the wiring pattern WP2 is shifted in the -X direction and the +Y direction with respect to the design position.

In this case, the determination unit 320 of the pattern determination unit 200B calculates the shift amount ΔX in the X direction, the shift amount ΔY in the Y direction, and the shift amount Δθz in the rotational direction around the axis extending in the Z direction with respect to the design position of each of the wiring pattern WP1 and the wiring pattern WP2 based on the position measurement results of the alignment marks AM1 and AM2 by the alignment detection system 250.

Then, the determination unit 320 determines a connection pattern that connects the wiring pattern WP1 and the wiring pattern WP2. The connection pattern is a pattern that is connected to the wiring pattern WP1 and is also connected to the wiring pattern WP2.

The data to form the connection pattern connecting the wiring patterns WP1 and WP2 is generated based on the wiring patterns WP1 and WP2 formed at the design positions. Therefore, for example, when the actual positions of the wiring patterns WP1 and WP2 are shifted from the design positions as illustrated in FIG. 14B, if the connection pattern designed based on the wiring patterns WP1 and WP2 formed at the design positions is formed without change, there is a possibility of a poor connection such as disconnection between the wiring patterns WP1 and WP2.

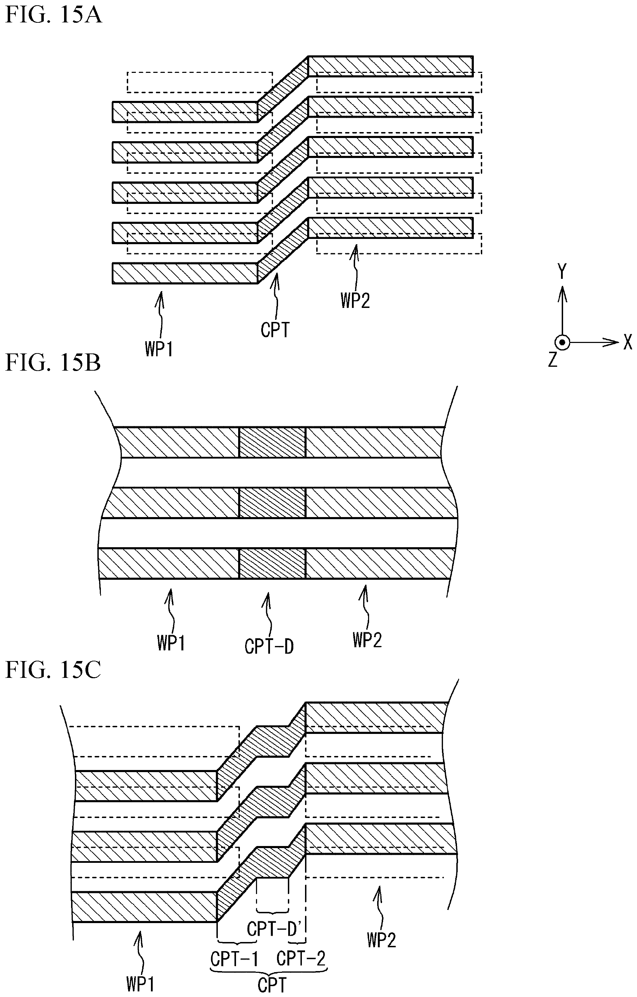

Therefore, for example, the determination unit 320 calculates the positions of the ends of the respective wiring lines included in the wiring patterns WP1 and WP2 from the respective shift amounts from the respective design positions of the wiring patterns WP1 and WP2. The determination unit 320 determines a connection pattern CPT that connects the ends of the wiring lines included in the wiring pattern WP1 and the wiring pattern WP2, for example, as illustrated in FIG. 15A, based on the calculated positions of the ends of the wiring lines. The same applies to the connection pattern between the wiring pattern WP3 and the wiring pattern WP4, the connection pattern between the wiring pattern WP1 and the wiring pattern WP3, and the connection pattern between the wiring pattern WP2 and the wiring pattern WP4.

The connection pattern for connecting the ends of the wiring lines may be generated by changing the connection pattern based on the design position stored in the storage unit 310, based on the respective shift amounts of the wiring patterns WP1 to WP4 from the respective design positions.

For example, it is assumed that a connection pattern CPT-D (which is referred to as a design value pattern) based on the wiring patterns WP1 and WP2 formed at the design positions is the pattern illustrated in FIG. 15B. In this case, as illustrated in FIG. 15C, the determination unit 320 may determine the connection pattern CPT by using a part CPT-D' of the design value pattern for the central portion of the region between the wiring pattern WP1 and the wiring pattern WP2, and by generating connection patterns CPT-1 and CPT-2 for connecting the wiring pattern formed in the central portion to the wiring patterns WP1 and WP2 for the other portion. That is, the design value pattern may be used for a predetermined region among regions between wiring patterns to be connected by the connection pattern, and a connection pattern for connecting the design value pattern and the actual wiring pattern may be generated for other regions. In this manner, the time required for data generation can be reduced as compared with that in the case where the data of the connection pattern is generated from scratch.

The pattern determination unit 200B determines a first connection pattern to be formed in the first connection region CR1 and a second connection pattern to be formed in the second connection region CR2. The first connection pattern includes a connection pattern that connects the wiring pattern WP1 and the wiring pattern WP2, and a connection pattern that connects the wiring pattern WP3 and the wiring pattern WP4. The second connection pattern includes a connection pattern that connects the wiring pattern WP1 and the wiring pattern WP3 and a connection pattern that connects the wiring pattern WP2 and the wiring pattern WP4.

In the present embodiment, the first connection pattern and the second connection pattern are formed using the second exposure device 200 that uses the spatial light modulator 221, and therefore, the first connection pattern and the second connection pattern can be made different. In the first connection pattern, the connection pattern connecting the wiring pattern WP1 and the wiring pattern WP2 and the connection pattern connecting the wiring pattern WP3 and the wiring pattern WP4 can be made different. In the second connection pattern, the connection pattern connecting the wiring pattern WP1 and the wiring pattern WP3 and the connection pattern connecting the wiring pattern WP2 and the wiring pattern WP4 can be made different. Thus, even when the wiring patterns WP1 to WP4 are formed to be shifted from the design positions, the wiring patterns can be reliably connected to each other.

The pattern determination unit 200B generates data to form the first connection pattern and data to form the second connection pattern, and outputs them to the second exposure control unit 260. The second exposure control unit 260 causes the pattern generation device 220 to generate the pattern based on the data output from the pattern determination unit 200B. First, the second exposure control unit 260 causes the pattern generation device 220 (spatial light modulator 221) to generate the pattern for forming the first connection pattern.

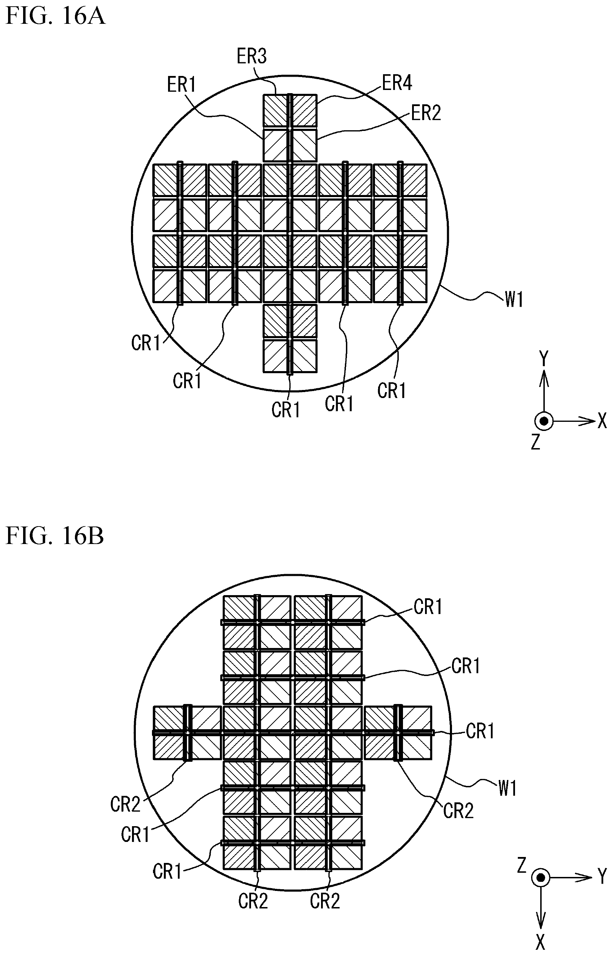

Referring back to FIG. 7, the exposure device main unit 200A forms the first connection pattern in the first connection region CR1 with the exposure light through the spatial light modulator 221 (step ST17). Specifically, the first connection pattern is formed in the first connection region CR1 by sequentially exposing the first connection region CR1 to the images generated by the light modulation surface of the spatial light modulator 221 based on the data generated by the pattern determination unit 200B (see FIG. 16A).

When step ST17 is completed, the orientation of the wafer W1 is changed around the axis (Z-axis) intersecting with the surface of the wafer W1 (step ST19). Specifically, the orientation of the wafer W1 is changed by 90° about the Z-axis. The orientation of the wafer W1 can be changed as illustrated in FIG. 16B by returning the wafer W1 from the stage 241 to the pre-alignment system, and rotating the wafer W1 by 90° about the Z-axis by the pre-alignment system. This aligns the Y-axis of the wafer W1 with the X1-axis of the second exposure system 200. During or after the execution of step ST19, the second exposure control unit 260 causes the pattern generation device 220 to generate the pattern for forming the second connection pattern.

Referring back to FIG. 7, the exposure device main unit 200A forms the second connection pattern in the second connection region CR2 with the exposure light through the spatial light modulator 221 (step ST21). Specifically, the second connection pattern is formed in the second connection region CR2 by sequentially exposing the second connection region CR2 to the images generated by the light modulation surface of the spatial light modulator 221 based on the data generated by the pattern determination unit CR2 (see FIG. 16B).

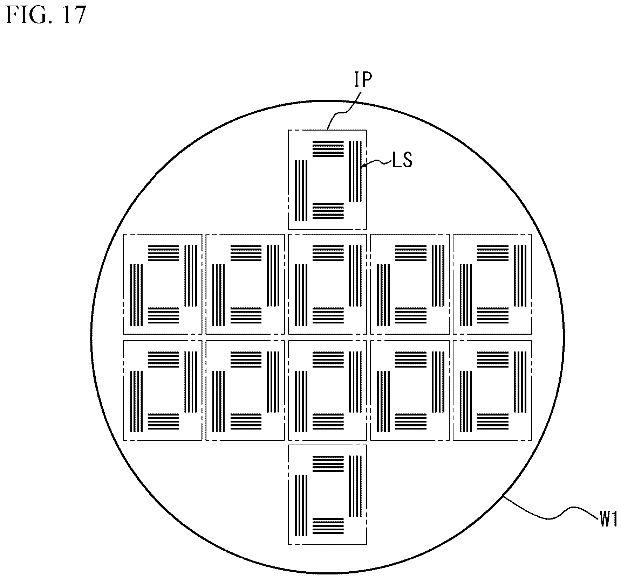

When the formation of the second connection pattern in the second connection region CR2 is completed, development and etching are performed (step ST23). More specifically, the insulating layer 12 is etched using the first connection pattern and the second connection pattern as a mask. The insulating layer 12 etched in step ST23 is the same insulating layer as the insulating layer 12 etched in step ST9. Thereafter, a metal film is formed, and an excess metal deposited is removed by CMP (Chemical Mechanical Polishing), whereby a metal wiring pattern is formed in the etched portions of the insulating layer. As a result, as illustrated in FIG. 17, the L/S pattern LS of the interposer IP is formed on the wafer W1.

Thereafter, the interposers IP are separated into individual pieces by dicing or the like (step ST25). Through the above process, the interposer IP can be manufactured.

As described above in detail, the exposure method according to the present embodiment includes forming the first exposure pattern EPT1 in the first region ER1 of each of the pattern formation regions PTR on the wafer W1 with the exposure light through the first reticle R1 and forming the second exposure pattern EPT2 in the second region ER2 separated from the first region ER1 in each of the pattern formation regions PTR with the exposure light through the second reticle R2 by using the first exposure device 100 using the reticle (photomask), and forming the connection pattern, which is determined based on the positions of the first exposure pattern EPT1 and the second exposure patten EPT2, between the first region ER1 and the second region ER2 of each of the pattern formation regions PTR by using the second exposure device 200 using the spatial light modulator 221 that modulates exposure light based on the output from the pattern determination unit 200B.

For example, when the L/S pattern of the interposer IP illustrated in FIG. 8A is formed by exposure by using only the exposure device using the reticle and using the stitching exposure technique, the throughput is high, but the stitching accuracy is generally greater than 20 nm. Therefore, it is difficult to narrow the line width (for example, 200 nm or less).

On the other hand, when the L/S pattern of the interposer IP illustrated in FIG. 8A is formed by exposure using only the exposure device using the spatial light modulator, the stitching accuracy is high, but the throughput is low. For example, when only an exposure device using a spatial light modulator is used, it may take about 15 times as long as the time required for exposure using only an exposure device using a reticle.

In the exposure method according to the present embodiment, since the most part of the pattern formation region PTR is exposed by the first exposure device 100 having a high throughput, and the stitching region is exposed using the second exposure device 200, it is possible to achieve a high stitching accuracy while achieving higher throughput than when using only an exposure device that uses a spatial light modulator. Particularly, stitching accuracy of about 10 nm or less can be achieved. This allows the line width to be reduced (e.g., 200 nm or less).

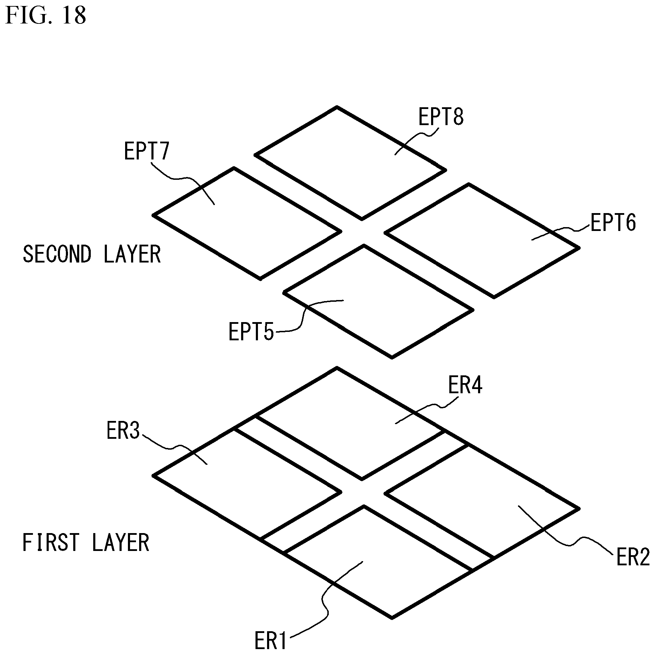

When fifth to eighth exposure patterns EPT5 to EPT8 are formed over the respective regions ER1 to ER4 of the first layer where the first to fourth exposure patterns EPT1 to EPT4 are formed, respectively as illustrated in FIG. 18, the stitching accuracy between the patterns formed in the respective regions ER1 to ER4 can be secured by forming the connection patterns using the second exposure device 200, and therefore it is only necessary to ensure the superimposition accuracy with the patterns formed in the respective regions ER1 to ER4 of the first layer in the first exposure system 100. Accordingly, in a case where a plurality of exposure patterns are superimposed, it is possible to achieve a high throughput while ensuring high stitching accuracy and high superimposition accuracy.

The exposure method according to the present embodiment includes changing the connection pattern formed by the exposure light through the spatial light modulator 221 based on the positions of the first exposure pattern EPT1 and the second exposure pattern EPT2. Since the connection pattern can be changed, even when the formation positions of the first exposure pattern EPT1 and the second exposure pattern EPT2 are shifted from the design positions, the first exposure pattern EPT1 and the second exposure pattern EPT2 can be reliably connected to each other, and the connection reliability of the wiring lines can be improved.

The exposure method according to the present embodiment includes measuring the position of the first exposure pattern EPT1 and the position of the second exposure pattern EPT2, and changing the connection pattern formed with the exposure light through the spatial light modulator 221 based on the measurement results of the positions of the first exposure pattern EPT1 and the second exposure pattern EPT2. This allows the connection pattern for connecting the first exposure pattern EPT1 and the second exposure pattern EPT2 to be determined based on the actual position of the first exposure pattern EPT1 and the actual position of the second exposure pattern EPT2, and therefore, the first exposure pattern EPT1 and the second exposure pattern EPT2 can be reliably connected, and the connection reliability of the wiring lines can be improved.

The exposure method according to the present embodiment further includes forming the third exposure pattern EPT3 in the third region ER3 different from the first region ER1 and the second region ER2 in each of the pattern formation regions PTR on the wafer W1 with the exposure light through the third reticle R3 by using the first exposure device 100 using a reticle. The first region ER1 and the second region ER2 are adjacent to each other in the X direction along the surface of the wafer W1, and the third region ER3 is adjacent to the first region ER1 in the Y direction intersecting the X direction. Further, the forming of the connection pattern with the exposure light through the spatial light modulator 221 includes forming the connection pattern between the first region ER1 and the second region ER2 adjacent to each other in the X direction with the exposure light through the spatial light modulator 221, and forming the connection pattern between the first region ER1 and the third region ER3 adjacent to each other in the Y direction with the exposure light through the spatial light modulator 221. Thus, an exposure pattern corresponding to the L/S pattern LS of the interposer IP can be formed in the pattern formation region PTR having an area about four times the projection area of the pattern formed on one reticle.

In the exposure method according to the present embodiment, after forming the first connection pattern between the first region ER1 and the second region ER2 adjacent in the X direction with the exposure light through the spatial light modulator 221, the orientation of the wafer W1 is changed around the Z-axis, and the second connection pattern is formed between the first region ER1 and the third region ER3 adjacent in the Y direction with the exposure light through the spatial light modulator 221. This allows the second connection pattern to be formed in a shorter time than in the case where the stage 241 is driven without changing the orientation of the wafer W1 about the Z-axis and the second connection pattern is formed with the exposure light through the spatial light modulator 221, and thus a high throughput can be achieved.

In the present embodiment, the connection pattern formed with the exposure light through the spatial light modulator 221 includes a pattern connected to the first exposure pattern ER1 formed by exposure in the first region EPT1. Thus, a wiring pattern connected to the wiring pattern WP1 formed based on the first exposure pattern EPT1 can be formed.

In the present embodiment, the first exposure pattern EPT1 and the second exposure pattern EPT2, and the connection pattern formed with the exposure light through the spatial light modulator 221 include the L/S patterns, and the widths of the L/S patterns are 200 nm or less. Since a thin L/S pattern can be formed, high-density wiring can be formed. Therefore, the number of communication channels can be increased, and high-speed communication between a logic circuit and a memory arranged on the interposer can be achieved, for example.

In the present embodiment, the first exposure pattern EPT1 is formed by exposing the first region ER1 to the image of the first pattern PT1 formed on the first reticle R1, and the second exposure pattern EPT2 is formed by exposing the second region ER2 to the image of the second pattern formed on the second reticle R2 different from the first reticle R1. Thus, even when the exposure patterns to be formed in the respective regions are different, the exposure patterns to be formed in the respective regions can be changed by changing the reticle.

According to the present embodiment, the method of manufacturing the interposer IP includes processing (etching) the surface (insulating layer 12) of the wafer W1 using the first exposure pattern EPT1 and the second exposure pattern EPT2 formed by the first exposure device 100 as a mask, and processing (etching) the surface (insulating layer 12) of the wafer W1 using the first connection pattern formed in the first connection region CR1 by the second exposure device 200 as a mask. Thus, the interposer IP having a large area, a high wiring density, and high connection reliability can be manufactured with high throughput.

According to the present embodiment, the second exposure device 200 includes the stage 241 on which the wafer W1 having the wiring patterns WP1 to WP4 formed in the regions ER1 to ER4 spaced apart from each other is placed, the pattern determination unit 200B that determines the connection pattern based on the measurement results of the wiring patterns WP1 to WP4, the spatial light modulator 221 that modulates and emits incident light based on the output from the pattern determination unit 200B, and the projection optical system 230 that projects the image of the light modulation surface of the spatial light modulator 221 between the adjacent regions of the regions ER1o to ER4. Thus, a connection pattern connecting at least any two of the wiring patterns WP1 to WP4 can be formed.

Further, according to the present embodiment, the exposure system ES includes the first exposure device 100 that forms exposure patterns in a plurality of regions spaced apart from each other in the pattern formation region PTR on the wafer W1 with the exposure light through a plurality of reticles, respectively, and the second exposure device 200 that includes the spatial light modulator 221, which modulates exposure light based on the output from the pattern determination unit 200B, and forms an exposure pattern between adjacent regions of the plurality of regions with the exposure light through the spatial light modulator 221. Thus, since most of the pattern formation region PTR is exposed by the first exposure device 100 having a high throughput and the stitching region is exposed by the second exposure device 200, the throughput can be made substantially equal to that in the case of using only an exposure device using a reticle, and high stitching accuracy can be achieved.

In the above embodiment, the case has been described where the number of regions exposed by the first exposure device 100 to the image of the pattern using the reticle R is four in the pattern formation region PTR corresponding to the interposer IP, but this does not intend to suggest any limitation. In the pattern formation region PTR, the number of regions exposed by the first exposure device 100 to the image of the pattern using the reticle R may be, for example, two, or five or more. In this case, the pattern determination unit 200B may determine the connection pattern so that the wiring patterns formed in the respective regions are connected as designed.

In the above embodiment, the positions of the first exposure pattern EPT1 to the fourth exposure pattern EPT4 (the positions of the wiring patterns WP1 to WP4) are measured by detecting the positions of the alignment marks AM1 to AM4 formed on the wafer W1. However, this does not intend to suggest any limitation. For example, a unique portion of a part of each of the first exposure pattern EPT1 to the fourth exposure pattern EPT4 (the wiring patterns WP1 to WP4) may be measured. That is, in each of the first exposure pattern EPT1 to the fourth exposure pattern EPT4, all of the first exposure pattern EPT1 to the fourth exposure pattern EPT4 may not be necessarily measured.

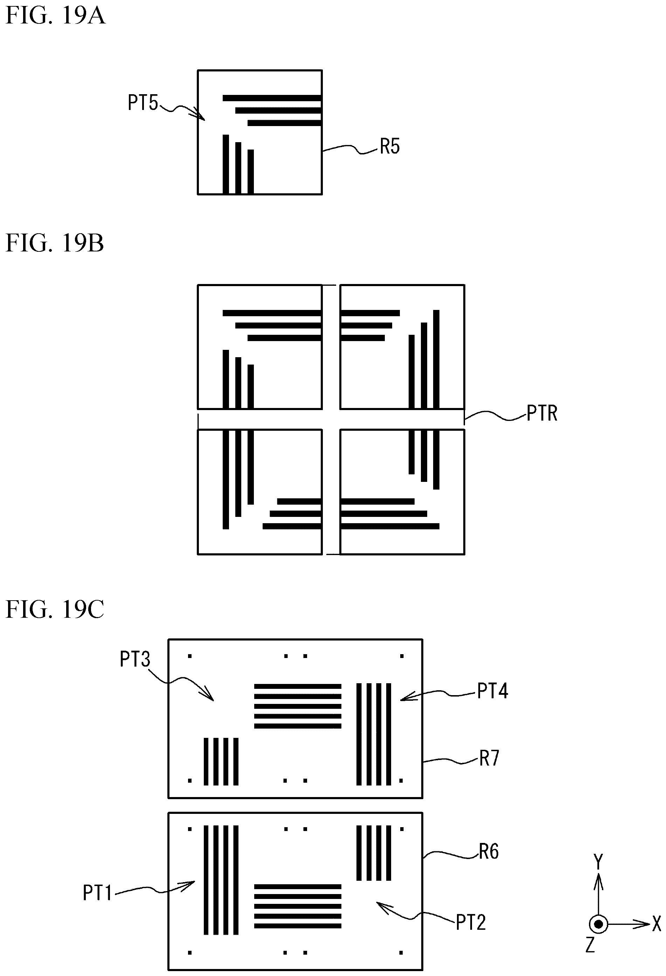

In the above embodiment, the first reticle R1 to the fourth reticle R4 on which different patterns are formed are used, but this does not intend to suggest any limitation. For example, a single reticle R5 on which a pattern PT5 illustrated in FIG. 19A is formed may be rotated as illustrated in FIG. 19B, and the pattern PT5 formed on the reticle R5 may be formed by exposure in a plurality of regions in the pattern formation region PTR.

In the above embodiment, as illustrated in FIG. 19C, the first exposure pattern EPT1 to the fourth exposure pattern EPT4 may be formed in the pattern formation region PTR using one reticle R6 including the first pattern PT1 formed on the first reticle R1 and the second pattern PT2 formed on the second reticle R2, and one reticle R7 including the third pattern PT3 formed on the third reticle R3 and the fourth pattern PT4 formed on the fourth reticle R4. The first exposure pattern EPT1 to the fourth exposure pattern EPT4 may be formed in the pattern formation region PTR using a reticle including the first pattern PT1 and the third pattern PT3 and a reticle including the second pattern PT2 and the fourth pattern PT4. By using such a reticle, step ST19 and step ST21 in FIG. 7 can be omitted, and thus the throughput can be further improved.

In the above embodiment, in each of the pattern formation regions PTR, a region including the first region ER1 and the second region ER2 may be defined as a first pattern formation region, a region including the third region ER3 and the fourth region ER4 may be defined as a second pattern formation region, a connection pattern connecting the wiring pattern WP1 and the wiring pattern WP2 may be formed between the first region ER1 and the second region ER2 in the first pattern formation region, and a connection pattern connecting the wiring pattern WP3 and the wiring pattern WP4 may be formed between the third region ER3 and the fourth region ER4 in the second pattern formation region. That is, the first connection region may be divided into two regions, and different connection patterns may be formed in the respective regions. Even in this case, the connection pattern corresponding to the actual formation positions of the wiring pattern WP1 and the wiring pattern WP2 and the connection pattern corresponding to the actual formation positions of the wiring pattern WP3 and the wiring pattern WP4 can be formed, and thus the connection reliability can be secured. The same applies to the second connection region.

In the above embodiment, the first connection pattern determined by the determination unit 320 of the pattern determination unit 200B may include a connection pattern that connects the wiring pattern WP1 and the wiring pattern WP4 and a connection pattern that connects the wiring pattern WP2 and the wiring pattern WP3. The second connection pattern may include a connection pattern that connects the wiring pattern WP1 and the wiring pattern WP4 and a connection pattern that connects the wiring pattern WP2 and the wiring pattern WP3.

Further, in the above embodiment, after the first connection pattern is formed, the orientation of the wafer W1 is changed by 90° around the Z-axis by the pre-alignment system, and then the second connection pattern is formed, but this does not intend to suggest any limitation. For example, after the first connection pattern is formed, the orientation of the spatial light modulator 221 may be changed around the axis (Z-axis) intersecting the light modulation surface of the spatial light modulator 221, and the second connection pattern may be formed. Alternatively, for example, after the first connection pattern is formed, the orientation of the wafer W1 may be changed by a predetermined angle around the Z-axis by the pre-alignment system, and the orientation of the spatial light modulator 221 may be changed by a predetermined angle around the Z-axis. The angle by which the orientation of the wafer W1 is changed and the angle by which the orientation of the spatial light modulator 221 is changed may be any angle as long as the second connection pattern can be formed in the second connection region CR2.

In the above embodiment, the connection pattern for connecting, for example, the wiring pattern WP1 and the wiring pattern WP2 is formed in the first connection region CR1, but this does not intend to suggest any limitation. For example, in the first connection region CR1, a connection pattern connected to one of the wiring pattern WP1 and the wiring pattern WP2 may be formed. For example, the exposure pattern formed in at least one of the first connection region CR1 and the second connection region CR2 may not necessarily include the connection pattern.

In the above embodiment, after the exposure of the images of the first pattern PT1 to the fourth pattern PT4 in the first exposure device 100, the development, etching, and resist application are performed, but this does not intend to suggest any limitation. For example, after the first exposure pattern EPT1 to the fourth exposure pattern EPT4 are formed in the first exposure device 100, the wafer W1 may be carried into the second exposure device 200, the positions of the alignment marks AM1 to AM4 as latent patterns formed by exposure on the resist may be measured, and the first connection pattern and the second connection pattern may be determined and formed.

That is, the wafer W1 on which the first exposure pattern EPT1 is formed in the first region ER1 in the pattern formation region PTR and the second exposure pattern EPT2 is formed in the second region ER2 spaced apart from the first region ER1 in the pattern formation region PTR may be placed on the stage 241 of the second exposure device 200, and the pattern determination unit 200B may determine the connection pattern based on the measurement results of the position of the first exposure pattern EPT1 and the position of the second exposure pattern EPT2.

As the alignment method using the latent image pattern, for example, a method disclosed in U.S. Patent No. 5440138 can be used. In this case, the number of times of development and etching can be reduced to one, and step ST 10 (resist application) of FIG. 6 can be omitted, so that the throughput can be improved.

In the above embodiment, the case of manufacturing the interposer has been described, but this does not intend to suggest any limitation, and the above embodiment can be applied to, for example, formation of a rewiring layer.

The above-described embodiment is a preferred example of the present invention. However, the present invention is not limited to this, and various modifications can be made without departing from the scope of the present invention.

### Description of Symbols

100 First exposure device
200 Second exposure device
200A Exposure device main unit
200B Pattern determination unit
221 Spatial light modulator
241 Stage
CPT Connection pattern
ES Exposure system
ER1 to ER4 First to fourth regions
EPT1 to EPT4 First to fourth exposure patterns
IP Interposer
LS1 to LS4 First to fourth L/S patterns
PTR Pattern formation region
PT1 to PT4 First to fourth patterns
R, R1 to R7 Reticle
W0, W1 Wafer
WP1 to WP4 Wiring pattern

## Claims

1. An exposure method comprising:
forming, by using an exposure device using a mask, a first exposure pattern in a first region of each of a plurality of pattern formation regions on a substrate with exposure light through a first mask, and forming a second exposure pattern in a second region spaced apart from the first region in each of the pattern formation regions with exposure light through a second mask; and
forming an exposure pattern determined based on positions of the first and second exposure patterns between the first and second regions in each of the pattern formation regions with exposure light through a spatial light modulator, using an exposure device that uses the spatial light modulator that modulates exposure light based on an output from an exposure pattern determination unit.

2. The exposure method according to claim 1, further comprising:
changing the exposure pattern formed with the exposure light through the spatial light modulator based on the positions of the first and second exposure patterns.

3. The exposure method according to claim 2, further comprising:
measuring a position of the first exposure pattern and a position of the second exposure pattern, and
wherein the changing of the exposure pattern formed with the exposure light through the spatial light modulator includes changing the exposure pattern formed with the exposure light through the spatial light modulator based on measurement results of the positions of the first and second exposure patterns.

4. The exposure method according to any one of claims 1 to 3,
wherein each of the pattern formation regions includes a first pattern formation region and a second pattern formation region, and
wherein the exposure pattern formed between the first region and the second region in the first pattern formation region is different from the exposure pattern formed between the first region and the second region in the second pattern formation region.

5. The exposure method according to any one of claims 1 to 4, further comprising:
forming a third exposure pattern in a third region different from the first and second regions in each of the pattern formation regions on the substrate with exposure light through a third mask by using an exposure device using a mask,
wherein the first and second regions are adjacent to each other in a first direction along a surface of the substrate,
wherein the third region is adjacent to the first region in a second direction intersecting the first direction, and
wherein the forming of the exposure pattern with the exposure light through the spatial light modulator includes forming the exposure pattern between the first and second regions adjacent to each other in the first direction with the exposure light through the spatial light modulator, and forming the exposure pattern between the first and third regions adjacent to each other in the second direction with the exposure light through the spatial light modulator.

6. The exposure method according to claim 5, wherein after the exposure pattern is formed between the first and second regions adjacent to each other in the first direction with the exposure light through the spatial light modulator, an orientation of the substrate is changed around an axis intersecting the surface and the exposure pattern is formed between the first and third regions adjacent to each other in the second direction with the exposure light through the spatial light modulator.

7. The exposure method according to claim 5 or 6, wherein after the exposure pattern is formed between the first and second regions adjacent to each other in the first direction with the exposure light through the spatial light modulator, an orientation of the spatial light modulator is changed around an axis intersecting a light modulation surface of the spatial light modulator, and the exposure pattern is formed between the first and third regions adjacent to each other in the second direction with the exposure light through the spatial light modulator.

8. The exposure method according to any one of claims 1 to 7, wherein the exposure pattern formed with the exposure light through the spatial light modulator includes a pattern connected to the first exposure pattern formed by exposure in the first region.

9. The exposure method according to any one of claims 1 to 8,
wherein the first and second exposure patterns and the exposure pattern formed with the exposure light through the spatial light modulator include a wiring pattern, and
wherein a width of the wiring pattern is 200 nm or less.

10. The exposure method according to any one of claims 1 to 9,
wherein the first exposure pattern is formed by exposing the first region to an image of a pattern formed on the first mask, and
wherein the second exposure pattern is formed by exposing the second region to an image of a pattern formed on the second mask different from the first mask.

11. An exposure method comprising:
forming a first exposure pattern in a first region in a pattern formation region on a substrate;
forming a second exposure pattern in a second region spaced apart from the first region in the pattern formation region; and
forming an exposure pattern in a third region between the first region and the second region based on measurement results of a position of the first exposure pattern and a position of the second exposure pattern.

12. The exposure method according to claim 11, wherein the exposure pattern formed in the third region includes a pattern connected to the first exposure pattern formed in the first region and a pattern connected to the second exposure pattern formed in the second region.

13. The exposure method according to claim 11 or 12, wherein the forming of the exposure pattern in the third region is performed using an exposure device that uses a spatial light modulator that modulates exposure light based on an output from an exposure pattern determination unit.

14. The exposure method according to claim 13, further comprising:
changing the exposure pattern formed in the third region based on the measurement results of the positions of the first and second exposure patterns.

15. A device manufacturing method comprising:
processing a surface of the substrate using the first and second exposure patterns formed using the exposure method according to any one of claims 11 to 14 as a mask; and
processing the surface of the substrate using the exposure pattern formed in the third region using the exposure method according to any one of claims 11 to 14 as a mask.

16. An exposure device comprising:
a substrate stage on which a substrate on which a first exposure pattern is formed in a first region within a pattern formation region and a second exposure pattern is formed in a second region spaced apart from the first region within the pattern formation region is placed;
an exposure pattern determination unit configured to determine an exposure pattern based on measurement results of a position of the first exposure pattern and a position of the second exposure pattern;
a spatial light modulator that modulates and emits incident light based on an output from the exposure pattern determination unit;
an illumination optical system that irradiates the spatial light modulator with illumination light; and
a projection optical system that projects an image of a light modulation surface of the spatial light modulator between the first and second regions.

17. An exposure device comprising:
a substrate stage on which a substrate on which wiring patterns are formed in a plurality of regions spaced apart from each other is placed;
an exposure pattern determination unit configured to determine an exposure pattern based on measurement results of positions of the wiring patterns;
a spatial light modulator that modulates and emits incident light based on an output from the exposure pattern determination unit;
an illumination optical system that irradiates the spatial light modulator with illumination light; and
a projection optical system that projects an image of a light modulation surface of the spatial light modulator between adjacent regions among the plurality of regions.

18. An exposure system comprising:
a first exposure device that forms exposure patterns in a plurality of regions spaced apart from each other in a pattern formation region on a substrate with exposure light through a plurality of masks, respectively; and
a second exposure device that includes a spatial light modulator, which modulates exposure light based on an output from an exposure pattern determination unit, and forms an exposure pattern between adjacent regions of the plurality of regions with exposure light through the spatial light modulator.
